# EUROPÄISCHE PATENTSCHRIFT

(11) **EP 3 996 862 B1**
(45) Veröffentlichungstag und Bekanntmachung des Hinweises auf die Patenterteilung: **20.09.2023**
(21) Anmeldenummer: 20734148.8
(22) Anmeldetag: 18.06.2020
(51) Int. Cl.: B23K 1/00, B23K 3/06, H05K 3/22, H05K 3/34, B23K 101/42

(54) **VERFAHREN ZUR REPARATUR EINER LEITERPLATTE UNTER VERWENDUNG EINES STIFTES ZUM ÜBERTRAGEN VON LOTPASTE AUS EINEM RESERVOIR AUF EINE KONTAKTSTELLE DER LEITERPLATTE**
METHOD FOR REPAIRING A CIRCUIT BOARD WITH USE OF A PEN FOR TRANSFERRING SOLDER PASTE FROM A RESERVOIR ONTO A CONTACT POINT OF THE CIRCUIT BOARD
PROCÉDÉ DE RÉPARATION D'UN CIRCUIT IMPRIMÉ UTILISANT UN STYLET POUR TRANSMETTRE DE LA PÂTE À BRASER D'UN RÉSERVOIR À UN POINT DE CONTACT DU CIRCUIT IMPRIMÉ

(30) Priorität: 09.07.2019 DE 102019118574
(43) Veröffentlichungstag der Anmeldung: 18.05.2022
(73) Patentinhaber: Endress+Hauser SE+Co. KG, 79689 Maulburg (DE)
(72) Erfinder: HIPPIN, Christoph, 79639 Grenzach (DE)
(74) Vertreter: Koslowski, Christine Adelheid
(86) Internationale Anmeldenummer: PCT/EP2020/066951
(87) Internationale Veröffentlichungsnummer: WO 2021/004752

(56) Entgegenhaltungen:
- DE-A1- 2 134 195
- DE-A1-102013 112 348
- DE-C3- 2 134 195
- JP-U- S51 106 225
- US-A- 5 186 982
- US-A- 5 909 839

## Beschreibung

Die Erfindung betrifft ein Verfahren zur Reparatur einer Leiterplatte mit zumindest einem defekten Bauteil mit Verwendung eines Stifts, siehe Anspruch 1.

Aus der Leiterplattenfertigung sind verschiedene Verfahren zur Bestückung der Leiterplatten bekannt. Beispielsweise werden so genannten SMD-Bauteile (Surface Mounted Device) auf Kontaktflächen auf der Vorderseite der Leiterplatte montiert. THT-Bauteile (Through-Hole-Technology) hingegen besitzen Anschlussdrähte, welche durch eine Öffnung in der Leiterplatte gesteckt und auf der gegenüberliegenden Seite der Leiterplatte befestigt werden. Hierbei ist auch eine Mischbestückung mit SMD und THT Bauteilen möglich. Das Löten von SMD-Bauteilen erfolgt in der Regel in einem Reflowverfahren. Zur Vorbereitung hierzu wird die Leiterplatte an den zu bestückenden Stellen mit Lotpaste versehen, welche ein Lotpastendepot bildet. Anschließend wird das Bauteil auf dem entsprechenden Lotdepot positioniert. Die so bestückte Leiterplatte wird einer Wärmequelle ausgesetzt, beispielsweise auf eine Heizplatte aufgelegt oder einem Lötofen zugeführt, wobei die Lotpaste aufgeschmolzen und hierdurch eine Verbindung des Bauteils mit der Leiterplatte hergestellt wird.

Aus US 5,186,982 ist ein Applikator für das punktuelle Aufbringen von Lotpaste auf eine Leiterkarte bekannt, der einen Durchtrittskanal aufweist, durch den Lotpaste aus einem Reservoir aus einer Austrittsöffnung des Applikators herausgedrückt wird. Der Durchtrittskanal weist einen Einlass für die Lotpaste auf. Ein Pin ist innerhalb des Durchtrittskanals beweglich geführt und dient dazu, wenigstens einen Teil der durch den Einlass in den Durchtrittskanal gelangte Lotpaste in Richtung der Austrittsöffnung und aus dieser herauszuschieben. Der Pin ist im Wesentlichen zylindrisch ausgestaltet und ragt aus einer Stirnfläche eines Grundkörpers hervor, wobei die Stirnfläche im Wesentlichen senkrecht zur Längsachse angeordnet ist.

In US 5,909,839 ist ein Verfahren zum Aufbringen eines Fluids auf eine Vielzahl an Positionen einer nicht-planaren Oberfläche mittels eines Pin-Arrays beschrieben.

In JP S51 106225 U ist ein Gerät zum elektrischen Löten mit einem Heizelement und einer an dem Heizelement lösbar befestigbaren Spitze beschrieben.

Es kann vorkommen, dass Bauteile fehlerhaft sind oder im Laufe des Betriebes ausfallen.

Insbesondere bei kostenintensiven Bauteilen oder bei Baugruppen mit einer Vielzahl an Bauteilen wird in einem solchen Fall nicht die komplette Baugruppe entsorgt, sondern das fehlerhafte oder defekte Bauteil ausgetauscht. Bisher werden defekte Bauteile auf bestückten Leiterplatten durch einen thermischen Prozess ausgelötet. Das Ersetzen, bzw. Wiedereinlöten erfolgt ebenfalls mittels eines thermischen Prozesses.

Von der Firma "ZEVAC" werden Maschinen vertrieben, welche ein Entfernen von Bauteilen mittels eines "Milling" genannten Verfahrens ermöglichen. Das Verfahren bietet die Möglichkeit, elektronische Bauteile mittels eines Fräsvorgangs von der Leiterplatte zu entfernen, wodurch ein thermischer Prozess vermieden wird. Der Fräskopf wird hierbei auf Höhe des Bauteils abgesenkt und anschließend eine Bewegung des Fräskopfes in x-y-Richtung durchgeführt, bis das gesamte Bauteile abgefräst ist. Die Leiterplatte wird dadurch weniger thermischem Stress ausgesetzt, wodurch einer künstlichen Alterung vorgebeugt wird.

Nachteile des Abfräsens unter x-y-Vorschubrichtungen, beispielsweise ein Abreißen von Kontaktpads der Leiterplatte oder Verschmieren von Lot, werden mittels eines Verfahrens, welches in der am selben Anmeldetag unter dem Titel "Verfahren zum Entfernen eines auf einer Leiterplatte aufgebrachten Bauteils" angemeldeten Patentanmeldung der Anmelderin offenbart ist, beseitigt. Die Anmeldung beschreibt ein Abfräsen der Lötverbindungen in z-Richtung durch das Bauteil hindurch, wodurch die Kontaktpads der Leiterplatte nicht belastet werden.

Nach Entfernen des Bauteils wird ein neues Bauteil auf die freigelegten Lötstellen aufgebracht werden. Neben den hierfür bekannten herkömmlichen Verfahren hat sich das aus der Patentanmeldung DE 10 2013 112 348 A1 (offenbarend den Oberbegriff des Anspruchs 1) bekannte Verfahren als besonders vorteilhaft herausgestellt. Hierbei wird ein Stift mit einem Lotauftragsstempel verwendet. Über den Lotauftragsstempel wird Lotpaste auf die Kontaktstellen der Leiterplatte transferiert, um so Lotpastendots von 10 µm bis 300 µm Durchmesser generieren zu können.

Es hat sich jedoch herausgestellt, dass bei Verwendung eines solchen Lotauftragsstempels Volumenschwankungen des transferierten Lotpastenvolumens auftreten, d.h. das transferierte Lotpastenvolumen schwankt mehr oder weniger stark.

In der Offenlegungsschrift DE 2134195 ist eine Vorrichtung zum Auftragen von Lötpaste auf Lötpunkte einer Leiterplatte beschrieben, die Dosierstempel aufweist, die mittels eines nieder- und hochfahrbaren Schlittens in Lötpaste eintauchen und nach dem wieder Hochfahren bei erneutem Niederfahren die aufgenommene Lötpaste auf die Lötpunkte auftragen. An ihrem Eintauchende weisen die Dosierstempel Aushöhlungen zur Aufnahme der Lötpaste auf.

Die Aufgabe der vorliegenden Erfindung besteht darin, ein Transferieren von Lotpaste mit einer höheren Wiederholgenauigkeit zu ermöglichen.

Die Aufgabe wird durch ein Verfahren zur Reparatur einer Leiterplatte mit zumindest einem defekten Bauteil gemäß Anspruch 1 gelöst.

Der im Verfahrenanspruch 1 verwendete Stift umfasst:
- Ein stabförmiges Element mit einer Rotationsachse in Längsrichtung;
- Einen Lotauftragsstempel, welcher aus einem Grundkörper mit einer Stirnfläche und einem aus der Stirnfläche hervorstehenden Pin besteht, wobei der Lotauftragsstempel eine Längsachse aufweist und derart an einem Endbereich des stabförmigen Elements angebracht ist, dass die Längsachse des Grundkörpers auf einer Verlängerung der Rotationsachse des stabförmigen Elements liegt,

wobei der Pin eine Längsachse aufweist und derart angeordnet ist, dass die Längsachse des Pins auf einer Verlängerung der Rotationsachse des stabförmigen Elements liegt,
wobei die Stirnfläche rotationssymmetrisch zur Längsachse des Pins ausgestaltet ist, und
wobei der Pin an einem ersten Endbereich eine Vorsprungsfläche aufweist und wobei die Vorsprungsfläche kleiner als die Stirnfläche ist.

Der Pin ist zylindrisch ausgestaltet, wobei die Stirnfläche derart ausgestaltet ist dass der Winkel zwischen der Längsachse des Pins und der Stirnfläche kleiner 180° ist, bevorzugt zwischen 60° und 120° ist, besonders bevorzugt im Wesentlichen 90° ist.

Die schwankenden Lotvolumen des im Stand der Technik beschriebenen Stifts haben ihre Ursache in der Geometrie des Lotauftragsstempels. So weisen diese Lotauftragsstempel fertigungsbedingt eine konkave Form zwischen dem Pin und der Stirnfläche des Grundkörpers auf. An dieser konkaven Form können die in der Lotpaste enthaltenen Lotkugeln nicht richtig anhaften. Abhängig vom Durchmesser der Lotkugeln erfahren diese mehr oder weniger Anhaftung aufgrund der Adhäsionskraft.

Die erfindungsgemäße Lösung sieht vor, diese konkave Übergangsstelle, bzw. Übergangsfläche zwischen dem Pin und der Stirnfläche durch eine Übergangsstelle mit einem definierten Winkel zwischen Pin und der Stirnfläche zu ersetzen. Die Stirnfläche ist hierbei mehr oder weniger gewölbt, um den Winkel zu etablieren. Bei einem Winkel kleiner als 180 ° werden die Lotkugeln unabhängig ihres Durchmessers an mindesten zwei Punkten durch die Adhäsionskraft festgehalten. Dies führt dazu, dass beim ersten Eintauchen des Stifts in ein Lotdepot, beispielsweise eine Dipwanne, diese Übergangsstelle mit einer Monolage von Lotkugeln, bzw. mit einem Ring Lotkugeln gefüllt wird. Die Lotkugeln verbleiben nach dem Transfer der Lotpaste in diesem Bereich. Durch einen sogenannten Andruckeffekt schwanken die ersten beiden gedruckten Lotpastendepots, auch Dots genannt, mitunter noch in dem Volumen der Lotpaste. Danach sind die übertragenen Volumina jedoch konstant.

Die weiteren Geometrien des Stifts entsprechen den Geometrien des aus dem Stand der Technik bekannten Stifts. Der erfindungsgemäß verwendete Stift ermöglicht ein Transferien von Lotpaste zum Generieren von Lotpastendepots, welche 10 µm bis 300 µm Durchmesser aufweisen, abhängig von den Abmessungen des Pins und des Stirnbereichs des Grundkörpers, sowie der verwendeten Lotpaste.

Beispielsweise ist vorgesehen, dass das Verhältnis der Stirnfläche zu der Vorsprungsfläche maximal einem Faktor 10, bevorzugt einem Faktur 7,5, besonders bevorzugt einem Faktor 5, entspricht. Der maximale Abstand zwischen der Stirnfläche und der Vorsprungsfläche, also die sichtbare Länge des Pins, liegt im Bereich von 50 bis 250 µm, bevorzugt 80 bis 150 µm. Die Vorsprungsfläche weist vorteilhafterweise einen Durchmesser im Bereich von 180 bis 300 µm auf, bevorzugt 130 µm bis 180 µm, besonders bevorzugt 50 µm bis 130 µm.

Gemäß einer bevorzugten Ausgestaltung des Stifts ist vorgesehen, dass der Grundkörper orthogonal zu der Rotationsachse des stabförmigen Elements einen quadratischen Querschnitt aufweist.

Gemäß einer alternativen Ausgestaltung des Stifts ist vorgesehen, dass der Grundkörper orthogonal zu der Rotationsachse des stabförmigen Elements einen kreisförmigen Querschnitt aufweist.

Gemäß einer vorteilhaften Ausgestaltung des Stifts ist vorgesehen, dass der Grundkörper beschichtet ist und wobei die Stirnfläche des Grundkörpers und der Pin unbeschichtet sind. Die Oberflächen des Grundkörpers sind also bis auf die Stirnfläche beschichtet. Die Beschichtung ist derart gewählt, dass diese eine Adhäsion der Lotpaste verhindert. Nach Eintauchen in das Lotdepot sind daher nur de Stirnfläche des Grundkörpers und der Pin mit Lotpaste bedeckt. Die Beschichtung ist insbesondere eine hydrophobe Plama- oder Nano-Beschichtung.

Gemäß einer bevorzugten Ausgestaltung des Stifts ist vorgesehen, dass das stabförmige Element und der Grundkörper ein gemeinsames einstückiges Bauteil sind.

Gemäß einer alternativen bevorzugten Ausgestaltung des Stifts ist vorgesehen, dass das stabförmige Element und der Grundkörper form- und/oder stoffschlüssig miteinander verbunden sind. Das stabförmige Element und der Grundkörper sind also zwei separate Bauteile. Diese werden beispielsweise mittels Schweißens, Lötens, Klebens oder Aufeinander-Steckens miteinander verbunden.

Gemäß einer bevorzugten Weiterbildung des Stifts ist vorgesehen, dass der Stift bis auf den Pin aus zwei Halbschalen besteht, die entlang der Längsachse verbindbar sind, wobei der Pin an einem ersten Endbereich ein Befestigungselement aufweist und wobei der Grundkörper eine Fassung zum Befestigen des Pins nach Zusammenfügen der Halbschalen aufweist, und wobei die Geometrie der Fassung im Wesentlichen der Geometrie des Befestigungselements entspricht. Der Stift besteht aus zwei Halbschalen und zwar unabhängig davon, ob das stabförmige Element und der Grundkörper einstückig oder mehrstückig ausgestaltet sind. Die Fassung dient zum Hineinlegen des erstem Endbereich des Pins. Nach Zusammenfügen der Halbschalen ist der Pin mechanisch in der Fassung befestigt, so dass kein Kleben oder Verschweißen notwendig ist. Jedoch kann dies als weiterer Sicherheitsschritt zusätzlich durchgeführt werden.

Eine vorteilhafte Ausgestaltung des Stifts sieht vor, dass das Befestigungselement in axialer Richtung des Pins keilförmig, zylinderförmig oder kombiniert keilförmig und zylinderförmig ausgestaltet ist. Damit ist ein Einklemmen des Befestigungselements in der Fassung gewährleistet. Alternativ können weitere Geometrien verwendet werden. Allen Geometrien gemein ist, dass das Befestigungselement einen größeren Querschnitt als der restliche radiale Querschnitt des Pins aufweisen muss, um eine Verankerung des Befestigungselements in der Fassung zu gewährleisten.

Der Stift kann durch ein Verfahren hergestellt werden, welches umfasst:
- Bereitstellen eines stabförmigen Elements;
- Anbringen eines Grundkörpers an einem Endbereich des stabförmigen Elements oder mechanisches Bearbeiten des Endbereichs des stabförmigen Elements zum Bilden des Grundkörpers;
- Bereitstellen eines Pins; und
- Befestigen des Pins an dem Grundkörper.

Der aus dem Stand der Technik bekannte Stift weist einen Lotauftragsstempel auf, welcher einstückig gefertigt ist. Hierbei wird der Grundkörper mittels eines Fräswerkzeugs bearbeitet, wodurch der Stift gebildet wird. Aufgrund der Geometrie des Fräswerkzeugs ist der Übergangsbereich zwischen Pin und Stirnfläche des Grundkörpers konkav ausgestaltet.

Der erfindungsgemäß verwendete Stift sieht vor, dass der Pin und der Grundkörper separate Elemente sind, welche im Herstellungsverfahren zusammengefügt werden. Nur so ist ein abrupter Übergang in Gestalt eines Winkels zwischen Pin und Stirnfläche ermöglicht.

Gegebenenfalls wird noch ein weiterer Verfahrensschritt durchgeführt, in welchem der Pins auf die passende, bzw. gewünschte Länge gekürzt wird. Die betrifft den Teil des Pins, welcher aus dem Grundkörper herausragt.

Gemäß einer ersten Variante des Verfahrens ist vorgesehen, dass eine Bohrung entlang der Rotationsachse des Grundkörpers erzeugt wird und wobei der Pin in die Bohrung eingesetzt und mit dem Grundkörper verklebt wird.

Gemäß einer vorteilhaften Ausgestaltung der ersten Variante des Verfahrens ist vorgesehen, dass die Bohrung mittels Laserbohrens oder mittels mechanischen Bohrens erzeugt wird. Alternativ ist die Verwendung jeglichen anderen Verfahrens möglich, welches eine Bohrung in den Abmessungen des Pins erlaubt.

Gemäß einer zweiten Variante des Verfahrens ist vorgesehen, dass der Befestigungsbereich des Pins in die Fassung eingesetzt wird und wobei die Halbschalen aufeinander platziert und form- und/oder stoffschlüssig miteinander verbunden werden. Eine formschlüssige Verbindung ist beispielsweise eine Schraubverbindung.

Gemäß einer vorteilhaften Ausgestaltung der zweiten Variante des Verfahrens ist vorgesehen, dass die Halbschalen mittels Schweißens oder Lötens miteinander verbunden werden. Alternativ ist die Verwendung jeglichen anderen Verfahrens vorgesehen, welches ein Zusammenfügen der Halbschalen ermöglicht.

Hinsichtlich des ererfindungsgemäßen Verfahrens ist vorgesehen, dass das defekte Bauteil über zumindest eine leiterplattenseitige Kontaktstelle mechanisch und/oder elektrisch mit der Leiterplatte verbunden ist, wobei das Verfahren, in welchem der Stift verwendet wird, zumindest folgende Schritte umfasst:
- Entfernen des defekten Bauteils von der Leiterplatte;
- Reinigen der mindestens einen leiterplattenseitigen Kontaktstelle;
- Aufbringen einer Lotpaste auf die mindestens eine gereinigte leiterplattenseitige Kontaktstelle mittels des Stifts, wobei der Lotauftragsstempel des Stifts zuerst in einem Benetzungsschritt zur Benetzung mit der Lotpaste in ein Reservoir mit Lotpaste zumindest teilweise abgesetzt wird und anschließend der benetzte Lotauftragsstempel in einem Übertragungsschritt auf der gewünschten leiterplattenseitigen Kontaktstelle abgesetzt wird, so dass ein Aufbringen bzw. Übertragen der Lotpaste auf die mindestens eine leiterplattenseitige Kontaktstelle ermöglicht wird;
- Bestücken der Leiterplatte mit einem für das defekte Bauteil vorhergesehenen Ersatzbauteil;
- Anlöten des Ersatzbauteils.

Der Stift ist daher zur Verwendung in einem Verfahren vorgesehen, wie dieses im Detail in der Patentanmeldung DE 10 2013 112 348 A1 beschrieben ist.

Die Erfindung wird anhand der nachfolgenden Figuren näher erläutert. Es zeigen
Fig. 1: eine schematische Darstellung eines Lotauftragsstempels, welcher aus dem Stand der Technik bekannt ist;
Fig. 2: eine schematische Darstellung der Untersicht des Lotauftragsstempels, welcher aus dem Stand der Technik bekannt ist;
Fig. 3: eine Skizze der Nachteile, welche der aus dem Stand der Technik bekannte Lotauftragsstempel verursacht;
Fig. 4: eine schematische Darstellung eines Stifts für das erfindungsgemäße Verfahren;
Fig. 5: eine schematische Darstellung der Untersicht einer ersten Variante des Stifts;
Fig. 6: eine schematische Darstellung der Untersicht einer zweiten Variante des Stifts;
Fig. 7: eine Skizze der Vorteile, welcher der Stift bietet; und
Fig. 8: eine schematische Darstellung eines Verfahrens zum Ersetzen eines defekten Bauteils auf einer Leiterplatte, in welchem der Stift Anwendung findet.

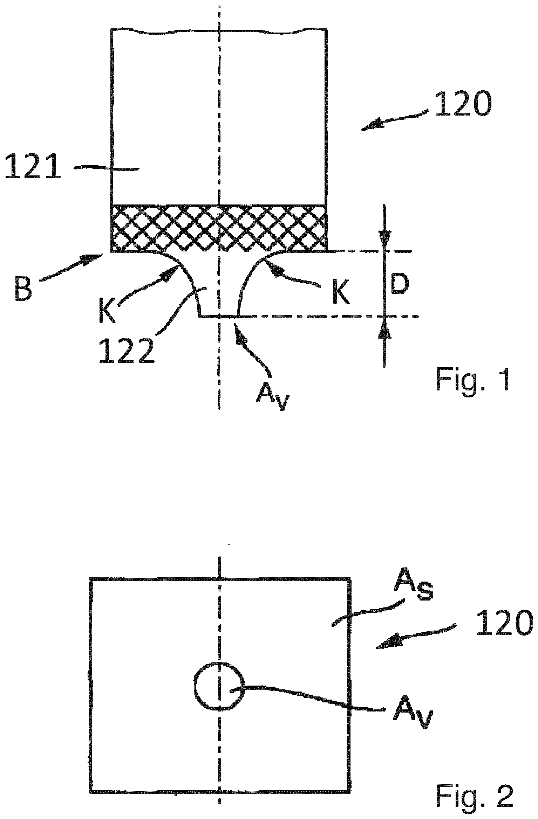

Fig. 1 zeigt eine schematische Darstellung eines Lotauftragsstempels 120, wie dieser aus einem im Stand der Technik offenbarten Stift bekannt ist. Ein solcher Stift 1 ist beispielsweise in der Patentanmeldung DE 10 2013 112 348 A1 offenbart. Dieser weist neben einem (hier nicht abgebildeten) stabförmigen Element, an welchem der Lotauftragsstempel befestigt den, den Lotauftragsstempel 120 selbst auf, welcher einen Grundkörper 121 mit einer Stirnfläche As umfasst. Aus der Stirnfläche As steht ein Pin 122 hervor, der eine Vorsprungsfläche Av aufweist, die vorzugsweise im Wesentlich parallel zur Stirnfläche As des Grundkörpers 121 verläuft. Der Pin 122 ist derartig ausgebildet, dass dieser im Längsschnitt eine zumindest abschnittsweise konkave Kontur K zwischen der Stirnfläche As und der Vorsprungsfläche Av aufweist. Über die konkave Kontur K nimmt der Lotauftragsstempel 120, wenn er in ein Reservoir 6 abgesetzt bzw. gebracht wird, Lotpaste auf.

Der maximale Abstand D der Vorsprungsfläche Av des Pins 122 zu der Stirnfläche As des Grundkörpers 121 liegt im Bereich von 50-400µm, bevorzugt im Bereich von 80-150µm. Als besonders geeignet hat sich ein maximaler Abstand von ca. 300 µm herausgestellt.

Der maximale Abstand D ist dabei derartig gewählt, dass sich die Stirnfläche As des Grundkörpers 121 mit Lotpaste 4 benetzt, wenn der Lotauftragsstempel 5 so in einem Lotreservoir abgesetzt wird, dass die Vorsprungsfläche As den Boden des Lotreservoirs berührt. Als Lotreservoir kann bspw. eine Dipwanne dienen, die bspw. eine Tiefe im Bereich von 700µm bis 400 µm, bevorzugt im Bereich von 400µm bis 200µm, besonders bevorzugt im Bereich von 200µm bis 40 µm aufweist.

Fig. 2 zeigt eine schematische Darstellung der Untersicht des Lotauftragsstempels 120. Die Stirnfläche As ist dabei quadratisch ausgebildet. Denkbar sind aber auch andere geometrische Formen, wie bspw. ein runder Querschnitt. Der Pin 122 und somit auch die Vorsprungsfläche As sind derartig ausgebildet, dass diese einen runden Querschnitt aufweisen. Die Querschnittsfläche des Pins 121 nimmt dabei von der Stirnfläche As, hin zur Vorsprungsfläche Av, stetig ab. Neben einem runden Querschnitt sind aber auch andere geometrische Formen, insbesondere rechteckige oder quadratische Querschnittsformen denkbar.

Die Querschnittsfläche des im Wesentlichen quadratischen Grundkörpers 121 weist eine Fläche auf, die im Bereich von 0,16 mm² bis 0,64 mm², bevorzugt im Bereich von 0,64 mm² bis 1 mm², besonders bevorzugt im Bereich von 1 mm² bis 2,25 mm² liegt.

Der Durchmesser der Vorsprungsfläche Av liegt, in Abhängigkeit der zu benetzenden Kontaktstelle, im Bereich von 300-180 µm, bevorzugt im Bereich von 180-130 µm, besonders bevorzugt im Bereich von 130-50 µm.

Weiterhin umfasst der in Fig. 1 dargestellte Lotauftragsstempel 120 eine hydrophobe Beschichtung B die zumindest auf einem Teil der Oberfläche des Grundkörpers 121 aufgebracht ist. Wie aus Fig. 1 ersichtlich wird, ist der Grundköper zumindest in dem an den Vorsprung angrenzenden Bereich mit der hydrophoben Beschichtung B versehen. Die hydrophobe Beschichtung B kann sich dabei weiter über den ganzen Grundkörper 121 bis zu der der Stirnfläche abgewandten Seite des Grundkörpers 121 erstrecken.

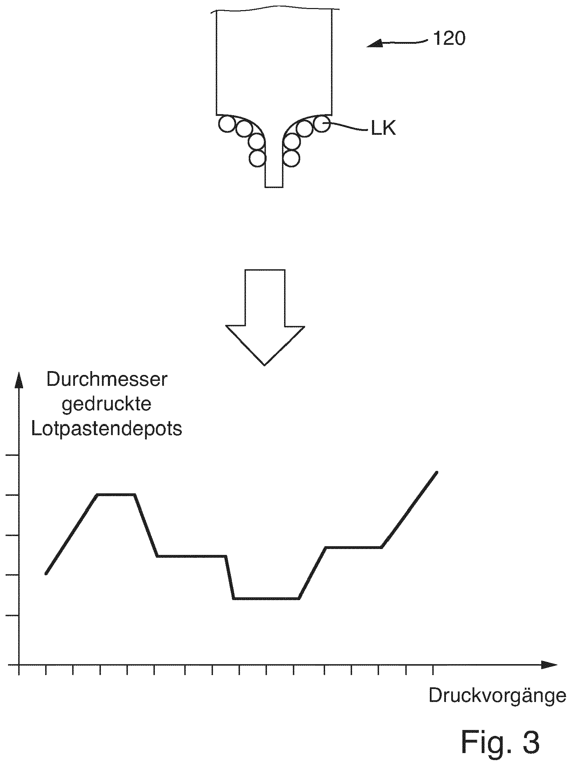

Fig. 3 skizziert einen der Nachteile, welcher der aus dem Stand der Technik bekannte Stift 1 aufweist. Bei Eintauchen des Lotauftragsstempels 120 in das Depot lagern sich die Lotpaste an der Stirnfläche Aₛ und an dem Pin 122 an. Die Lotpaste besteht aus mehreren kleinen Lotkugeln LK. Die Lotkugeln LK berühren die Stirnfläche Aₛ oder den Pin 122 mit jeweils einem Punkt ihrer Oberfläche und haften nur sehr schlecht an der jeweiligen Oberfläche. Da die Lotkugeln unterschiedlich groß sind, haften diese mal besser und mal schlechter an der jeweiligen Oberfläche. Die Verteilung der Lotkugeln auf der Stirnfläche Aₛ und dem Pin 122 ist darüber hinaus bei jedem Dipvorgang unterschiedlich.

Als Resultat davon fällt jeder Druckvorgang unterschiedlich aus, wie in Fig. 3 unten im Diagramm gezeigt ist. Das Diagramm zeigt einen Test verschiedener Druckvorgänge. Auf der Abszisse ist die Anzahl des jeweiligen Drucks eingezeichnet. Auf der Ordinate ist der Durchmesser des bei dem jeweiligen Druck resultierten Lotpastendepots dargestellt. Wie aus dem Diagramm ersichtlich, schwankt der Durchmesser der gedruckten Lotpastendepots stark von Druck zu Druck. Reproduzierbare Druckergebnisse lassen sich durch das Verwenden eines solchen Lotauftragsstempels 120 nicht erzielen. Ebenso ist die Fertigung eines solchen Lotauftragsstempels 120 sehr aufwendig.

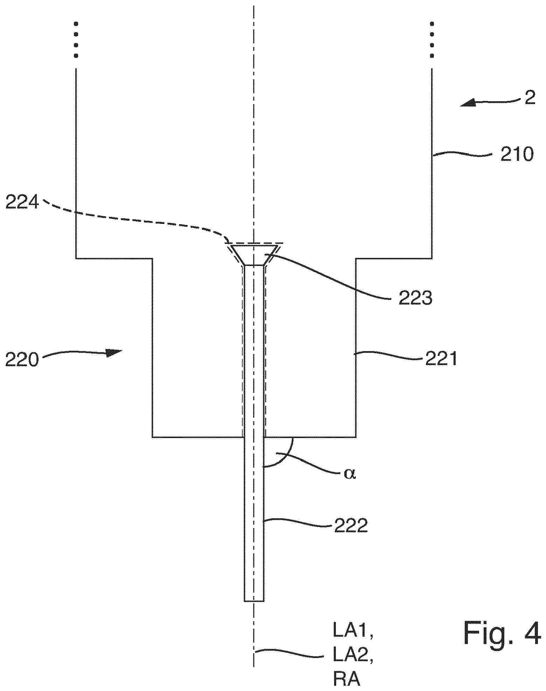

Fig. 4 zeigt eine schematische Darstellung eines Stifts 2 für das erfindungsgemäße Verfahren.

Die grundlegenden Dimensionen des Stifts entsprechen derer des in Fig. 1 gezeigten Stifts 1, welcher aus dem Stand der Technik bekannt ist. Der Stift 2 unterscheidet sich im Wesentlichen in der Anordnung und der Fertigung des Pins 222 von dem aus dem Stand der Technik bekannten Stift 1. So ist der Pin 222 nicht aus dem Grundkörper 221 gefertigt, sondern ist ein separates Bauteil, welches in den Grundkörper 221 eingefügt ist. Beispielsweise wird hierfür eine Bohrung in den Grundkörper 221 eingefügt. Die Bohrachse verläuft entlang einer Rotationsachse RA des stabförmigen Elements 210, bzw. der Längsachse LA1 des Grundkörpers 221, welche auf einer Verlängerung der Rotationsachse RA liegt. Anschließend wird der Pin 222 eingelegt und verklebt. Die Längsachse LA2 des Pins 222 liegt dadurch auf einer Verlängerung der Rotationsachse RA, bzw. auf der Längsachse LA1 des Grundkörpers 221. Diese Variante ist in Fig. 4 nicht abgebildet.

Eine weitere Variante, wie in Fig. 4 abgebildet, besteht darin, dass der Stift 2, genauer das stabförmige Element 210 und der Grundkörper 221, aus jeweils zwei Halbschalen HS1, HS2 bestehen. Vorteilshafterweise sind der Grundkörper 221 und das stabförmige Element 210 bereits form- oder stoffschlüssig miteinander verbunden, so dass insgesamt nur zwei Halbschalen HS1, HS2 benötigt werden.

Der Pin 222 wird in die Halbschalen HS1, HS2 eingelegt, anschließend werden die Halbschalen HS1, HS2 fest miteinander verbunden, beispielsweise mittels Lötens oder Schweißens. Der Pin 222 verhakt in den Halbschalen und ist dadurch befestigt. Das wird dadurch realisiert, dass der Pin 222 einen Endbereich in Form eines Befestigungselements 223 aufweist, welcher gegenüber dem radialen Querschnitt des Pins 222 vergrößert ist. Beispielsweise ist das Befestigungselement 223 trapezförmig oder zylinderförmig, bzw. eine Mischung aus beiden, ausgestaltet. Die Halbschalen weisen eine zu der Form und den Dimensionen des Befestigungselements 223 korrespondierende Fassung 224 auf.

Das Befestigungselement 223 wird in die Fassung 224 gelegt. Durch Schließen der Halbschalen wird das Befestigungselement in der Fassung 224 fixiert, so dass der Pin 222 fest am Grundkörper 221 angebracht ist. Optional kann das Befestigungselement 223 noch in der Fassung 224 verklebt werden.

Beide Varianten sind dadurch gekennzeichnet, dass der Übergang zwischen dem Pin 222 und der Stirnfläche A_{z} sprunghaft ist, also ein Winkel α ausgebildet ist. Im vorliegenden Beispiel ist der Winkel im Wesentlichen 90 °. Es kann jedoch auch vorgesehen sein, dass die Stirnfläche Az vom Übergangspunkt zum Pin 222 stetig ansteigt oder absteigt, also der Endbereich des Grundkörpers konusförmig oder invers-konusförmig ausgestaltet ist. Dadurch kann der Winkel auch in einem Bereich 0 < α < 90 ° oder 90 ° < α < 180 ° liegen.

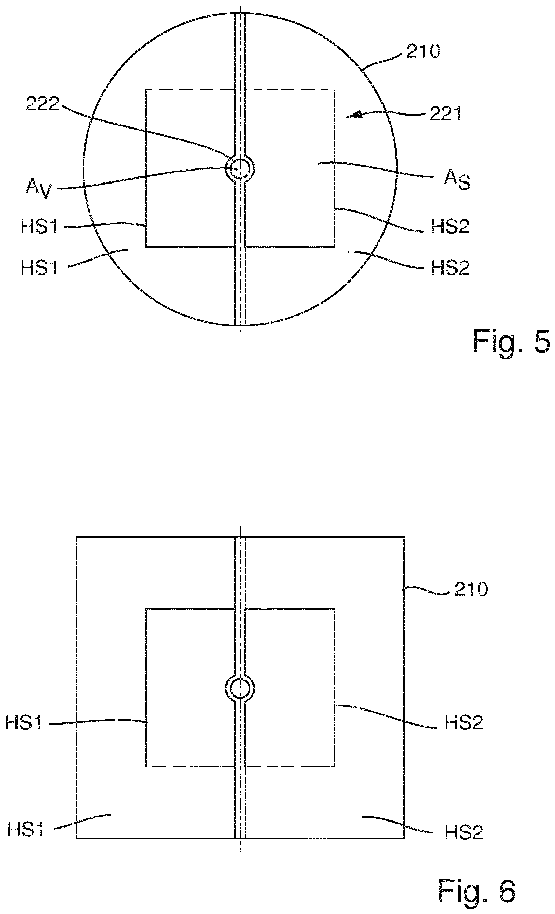

Fig. 5 zeigt eine schematische Darstellung der Untersicht einer ersten Variante des Lotauftragsstempels 120. Die Stirnfläche As ist dabei quadratisch ausgebildet. Denkbar sind aber auch andere geometrische Formen, wie bspw. ein runder Querschnitt. Der Pin 122 und somit auch die Vorsprungsfläche As sind derartig ausgebildet, dass diese einen runden Querschnitt aufweisen. Neben einem runden Querschnitt sind aber auch andere geometrische Formen, insbesondere rechteckige oder quadratische Querschnittsformen denkbar. Ersichtlich sind außerdem die beiden Halbschalen HS1, HS2, aus denen das stabförmige Element 210 und der Grundkörper 221 bestehen.

Fig. 6 zeigt eine schematische Darstellung der Untersicht einer zweiten Variante des Lotauftragsstempels 120. Die Stirnfläche As ist dabei quadratisch ausgebildet. Hier ist der Querschnitt des stabförmigen Elements 210 im Wesentlichen quadratisch ausgestaltet. Auch bei dieser Variante können die Querschnitte des Pins 222 und des Grundkörpers 221 verschiedene Formen, beispielsweise quadratisch oder rund, aufweisen.

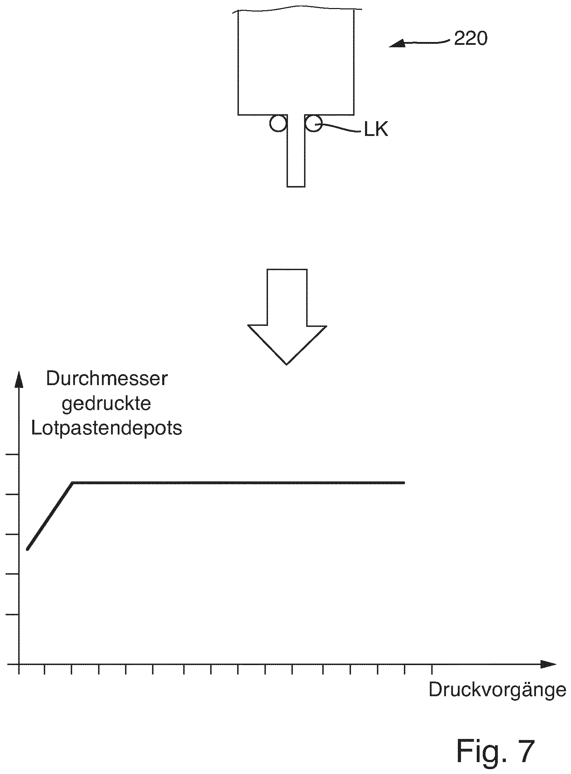

Ein Vorteil eines solchen Stifts 2 liegen in einer vereinfachten Fertigung des Stifts 2. Ein weiterer, wesentlicher Vorteil des Stifts 2 ist in Fig. 7 gezeigt:
Bei Eintauchen des Lotauftragsstempels 220 in das Depot lagern sich die Lotpaste an der Stirnfläche Aₛ und an dem Pin 122 an. Die Lotpaste besteht aus mehreren kleinen Lotkugeln LK.

Eine Lage von Lotkugeln LK berührt die Stirnfläche Aₛ und den Pin 122 mit jeweils einem Punkt ihrer Oberfläche. Jede der Lotkugeln dieser Lage weist daher 2 Punkte auf, welche den Lotauftragsstempel berühren. Dadurch ist die Haftung dieser Lage der Lotkugeln LK vergleichsweise hoch. Diese Lage der Lotkugeln entsteht nur bei einem Stift 2, welcher den Winkel α zwischen dem Pin 222 und der Stirnfläche A_{z} ausbildet. Nach einem Druck der Lotpaste ist die Lage der Lotkugeln LK weiterhin vorhanden. Weitere Lotkugeln LK lagern sich bei Eintauchen in das Depot immer in einem ähnlichen Muster an den Lotauftragsstempel 220 an, bedingt durch die Einzellage der Lotkugeln.

Wie im Diagramm der Fig. 6 ersichtlich, ist die Reproduzierbarkeit der gedruckten Lotpastendepots in puncto Durchmesser gegenüber dem im Stand der Technik beschriebenen Stift 1 wesentlich erhöht. Durch einen sogenannten Andruckeffekt schwanken die ersten beiden gedruckten Lotpastendepots mitunter noch in dem Volumen der Lotpaste. Danach sind die übertragenen Volumina jedoch konstant.

Im Folgenden sei eine Anwendung des Stifts beschrieben
Im ersten Schritt wird ein defektes Bauteil 6, welches über Kontaktstellen 3 mechanisch und/oder elektrisch auf einer Leiterplatte 5 befestigt ist, entfernt. Hierfür eignet sich beispielsweise das in der am selben Anmeldetag angemeldeten Patentanmeldung mit dem Titel "Verfahren zum Entfernen eines auf einer Leiterplatte aufgebrachten Bauteils" offenbarte Verfahren.

Im zweiten Schritt werden sämtliche leiterplattenseitigen Kontaktstellen 3, die zur Anbindung des defekten Bauteils 6 an die Leiterplatte 5 gedient haben, gereinigt. Vorzugsweise findet diese Reinigung berührungslos satt. Hierzu wird die Automatisierungsanlage mit einer Mehrkanal-Reinigungsdüse bestückt. Die Mehrkanal-Reinigungsdüse ist wiederum derartig ausgebildet, dass sie zum einen Heißluft abgeben und zum anderen ein Vakuum bzw. Luft ziehen kann, wobei die angesaugte Luft durch einen Bypass über ein Filter geführt wird. Mittels der Mehrkanal-Reinigungsdüse werden die Kontaktstellen 3 abgefahren, wobei durch die Heißluft das restliche Lot, welches nach dem Entfernen des defekten Bauteils 5 noch vorahnden ist, erhitz wird, um es anschließend entfernen zu können.

Im dritten Schritt wird eine Lotpaste 4 auf den gereinigten leiterplattenseitigen Kontaktstellen 3 aufgebracht. Hierzu wird die Automatisierungsanlage mit einem Lotauftragsstempel 2 bestückt, der zum Übertrag bzw. Transfer von der Lotpaste 4 aus einem Reservoir auf die Kontaktstelle 3 dient. Anschließend wird der Lotauftragsstempel 2 von einer Positioniereinheit der Automatisierungsanlage über das Reservoir gefahren und in dem Reservoir zumindest teilweise abgesetzt, so dass eine Benetzung des Lotauftragsstempels 2 erfolgt. Hierbei wird der Lotauftragsstempel 2 nur bis zu einer vordefinierten ersten Kraft, bspw. 1 N, in das Reservoir abgesetzt.

Im Anschluss daran, wird der mit Lotpaste 4 benetzte Lotauftragsstempel 2 wieder aus dem Reservoir zu einer zuvor festgelegten Position auf der Leiterplatte 5, an der das Ersatzbauteil 7 vorgesehen ist, gefahren. An der festgelegten bzw. vordefinierten Position wird der Lotauftragsstempel 2 auf der leiterplattenseitigen Kontaktstelle 3, bspw. einem Kupferpad, abgesetzt, so dass ein Aufbringen bzw. Übertragen der Lotpaste 4 auf die Kontaktstelle 3 erfolgt. Hierbei wird der Lotauftragsstempel 2 mit einer vordefinierten zweiten Kraft, bspw. 0,7N auf der Kontaktstelle 3 abgesetzt. Die Positioniereinheit der Automatisierungsanlage verfährt den Lotauftragsstempel 2 kraftgesteuert, d.h. die beim Aufsetzen bzw. Aufpressen des Lotauftragsstempels 52 auf die Kontaktstelle 3 wirkende Kraft wird von der Positioniereinheit kontrolliert und in dem Fall, dass die wirkende Kraft eine vordefinierte (erste und/oder zweite) Kraft überschreitet, wird der Absetzvorgang angehalten bzw. gestoppt.

Als Reservoir kann bspw. eine Dipwanne dienen, die eine definierte Tiefe aufweist. In die Dipwanne wird die Lotpaste 4 eingebracht und anschließend die überflüssige Lotpaste 4 mittels eines Rakels entfernt. Auf diese Weise lässt sich eine sehr reproduzierbare Menge an Lotpaste 4 in dem Reservoir bzw. der Dipwanne realisieren. Zusätzlich kann das Reservoir bzw. die Dipwanne eine Nanobeschichtung aufweisen, um so ein einfacheres Herauslösen der Lotpaste 4 zu ermöglichen.

In dem Fall, dass mehrere Kontaktstellen 3 mit Lotpaste 4 versehen werden sollen, wird der dritte Schritt entsprechend mehrfach wiederholt.

Im vierten Schritt wird die Leiterplatte 5 mit einem für das defekte Bauteil 6 vorgesehenen Ersatzbauteil 7 bestückt. Dabei wird beispielsweise eine Mehrkanal-Ringdüse verwendet, um das Ersatzbauteil 7 aus einem Bauteil-Gurt herauszulösen und an die gewünschte Position auf der Leiterplatte 5 zu befördern.

Im fünften Schritt wird das zuvor auf der Leiterplatte 5 platzierte Ersatzbauteil 7 angelötet. Dabei wird das auf der vorgewärmten Leiterplatte 5 platzierte Ersatzbauteil 7 mittels der Heißluftfunktion der Mehrkanal-Ringdüse an der Leiterplatte 5 angelötet.

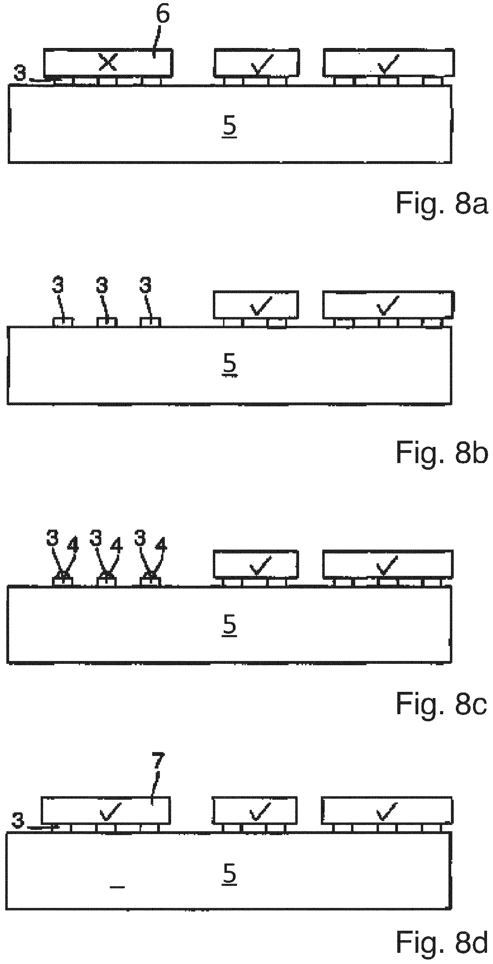

Fig. 8 zeigt eine schematische Darstellung zur Verdeutlichung des Verfahrensablaufes. Dabei ist in Fig. 8 a) exemplarisch eine Leiterplatte 5 mit drei Bauteilen dargestellt, wobei das linke Bauteil 6 defekt ist. Dieses defekte Bauteil 6 wird gemäß dem oben beschriebenen ersten Schritt entfernt. Fig. 8 b) zeigt die Leiterplatte 5, bei der das defekte Bauteil 6 entfernt ist und die leiterplattenseitigen Kontaktstellen 3 gereinigt sind. Fig. 8 c) zeigt die Leiterplatte 5, bei der die Lotpaste 4 auf die Kontaktstellen 3 aufgebracht ist. Fig. 8 d) zeigt die Leiterplatte 1 mit dem angelöteten Ersatzbauteil 7.

### Bezugszeichenliste

- 1, 2: Stift
- 210: stabförmiges Element
- 120, 220: Lotauftragsstempel
- 121, 221: Grundkörper
- 122,222: Pin
- 223: Befestigungselement
- 224: Fassung
- 3: Kontaktstelle
- 4: Lotpaste
- 5: Leiterplatte
- 6: defektes Bauteil
- 7: Ersatzbauteil
- Aₛ: Stirnfläche
- Aᵥ: Vorsprungsfläche
- B: Beschichtung
- D: Länge Pin, bzw. maximaler Abstand Aₛ zu Aᵥ
- HS1, HS2: Halbschalen
- K: Kontur
- LA1: Längsachse des Grundkörpers
- LA2: Längsachse des Stifts
- LK: Lotkugeln
- RA: Rotationsachse
- α: Winkel

## Patentansprüche

1. Verfahren zur Reparatur einer Leiterplatte mit zumindest einem defekten Bauteil, wobei das defekte Bauteil über zumindest eine leiterplattenseitige Kontaktstelle mechanisch und/oder elektrisch mit der Leiterplatte verbunden ist,
**gekennzeichnet durch**:
die Verwendung eines Stifts (2), wobei der Stift (2) umfasst:
- Ein stabförmiges Element (210) mit einer Rotationsachse (RA) in Längsrichtung;
- Einen Lotauftragsstempel (220), welcher aus einem Grundkörper (221) mit einer Stirnfläche (Aₛ) und einem aus der Stirnfläche (Aₛ) hervorstehenden Pin (222) besteht, wobei der Lotauftragsstempel (220) eine Längsachse (LA1) aufweist und derart an einem Endbereich des stabförmigen Elements (210) angebracht ist, dass die Längsachse (LA1) des Grundkörpers (221) auf einer Verlängerung der Rotationsachse (RA) des stabförmigen (210) Elements liegt,
wobei der Pin (222) eine Längsachse (LA2) aufweist und derart angeordnet ist, dass die Längsachse (LA2) des Pins (222) auf einer Verlängerung der Rotationsachse (RA) des stabförmigen Elements (210) liegt,
wobei die Stirnfläche (Aₛ) rotationssymmetrisch zur Längsachse (LA2) des Pins (222) ausgestaltet ist, und
wobei der Pin (222) an einem ersten Endbereich eine Vorsprungsfläche (Aᵥ) aufweist und wobei die Vorsprungsfläche kleiner als die Stirnfläche (Aₛ) ist;
wobei der Pin (222) zylindrisch ausgestaltet ist, und
wobei die Stirnfläche (Aₛ) derart ausgestaltet ist, dass der Winkel (α) zwischen der Längsachse (LA2) des Pins (222) und der Stirnfläche (Aₛ) kleiner 180° ist, bevorzugt zwischen 60° und 120° ist, besonders bevorzugt im Wesentlichen 90° ist,
wobei das Verfahren zumindest folgende Schritte umfasst:
- Entfernen des defekten Bauteils von der Leiterplatte;
- Reinigen der mindestens einen leiterplattenseitigen Kontaktstelle;
- Aufbringen einer Lotpaste auf die mindestens eine gereinigte leiterplattenseitige Kontaktstelle mittels des Stifts (2), wobei der Lotauftragsstempel (220) des Stifts (2) zuerst in einem Benetzungsschritt zur Benetzung mit der Lotpaste in ein Reservoir mit Lotpaste zumindest teilweise abgesetzt wird und anschließend der benetzte Lotauftragsstempel (220) in einem Übertragungsschritt auf der gewünschten leiterplattenseitigen Kontaktstelle abgesetzt wird, so dass ein Aufbringen bzw. Übertragen der Lotpaste auf die mindestens eine leiterplattenseitige Kontaktstelle ermöglicht wird;
- Bestücken der Leiterplatte mit einem für das defekte Bauteil vorhergesehenen Ersatzbauteil;
- Anlöten des Ersatzbauteils.

2. Verfahren nach Anspruch 1, wobei der Grundkörper (221) orthogonal zu der Rotationsachse (RA) des stabförmigen Elements (210) einen quadratischen Querschnitt aufweist.

3. Verfahren nach Anspruch 1, wobei der Grundkörper (221) orthogonal zu der Rotationsachse (RA) des stabförmigen Elements (210) einen kreisförmigen Querschnitt aufweist.

4. Verfahren nach einem der vorherigen Ansprüche, wobei der Grundkörper (221) beschichtet ist und wobei die Stirnfläche (Aₛ) des Grundkörpers (221) und der Pin (222) unbeschichtet sind.

5. Verfahren nach einem der vorherigen Ansprüche, wobei das stabförmige Element (210) und der Grundkörper (221) ein gemeinsames einstückiges Bauteil sind.

6. Verfahren nach einem der Ansprüche 1 bis 4, wobei das stabförmige Element (210) und der Grundkörper (221) form- und/oder stoffschlüssig miteinander verbunden sind.

7. Verfahren nach einem der vorherigen Ansprüche, wobei der Stift (2) bis auf den Pin (222) aus zwei Halbschalen (HS1, HS2) besteht, die entlang der Rotationsachse (RA) verbindbar sind, wobei der Pin (222) an einem zweiten Endbereich ein Befestigungselement (223) aufweist und wobei der Grundkörper (221) eine Fassung (224) zum Befestigen des Pins (222) nach Zusammenfügen der Halbschalen (HS1, HS2) aufweist, und wobei die Geometrie der Fassung (224) im Wesentlichen der Geometrie des Befestigungselements (223) entspricht.

8. Verfahren nach Anspruch 7, wobei das Befestigungselement (223) in axialer Richtung des Pins (222) keilförmig, zylinderförmig oder kombiniert keilförmig und zylinderförmig ausgestaltet ist.

## Claims

1. A method for repairing a printed circuit board having at least one defective component, wherein the defective component is mechanically and/or electrically connected to the printed circuit board by means of at least one contact point on the printed circuit board,
**characterized by**:
the use of a pen (2), wherein the pen (2) comprises:
- a rod-shaped element (210) with an axis of rotation (RA) in the longitudinal direction;
- a solder application pad (220), which consists of a main body (221) with an end face (A_{S}) and a pin (222) projecting from the end face (As), wherein the solder application pad (220) has a longitudinal axis (LA1) and is mounted on an end region of the rod-shaped element (210) in such a way that the longitudinal axis (LA1) of the main body (221) lies on an extension of the axis of rotation (RA) of the rod-shaped element (210),
wherein the pin (222) has a longitudinal axis (LA2) and is arranged in such a manner that the longitudinal axis (LA2) of the pin (222) lies on an extension of the axis of rotation (RA) of the rod-shaped element (210),
wherein the end face (A_{S}) is designed with rotational symmetry about the longitudinal axis (LA2) of the pin (222), and
wherein the pin (222) has a projection area (A_{V}) on a first end region,
and wherein the projection area is smaller than the end face (As);
wherein the pin (222) is designed to be cylindrical, and
wherein the end face (A_{S}) is designed such that the angle (α) between the longitudinal axis (LA2) of the pin (222) and the end face (A_{S}) is less than 180°, preferably between 60° and 120°, particularly preferably substantially 90°,
wherein the method comprises at least the following steps:
- removing the defective component from the printed circuit board;
- cleaning the at least one contact point on the printed circuit board;
- using the pen (2) to apply a solder paste to the at least one cleaned contact point on the printed circuit board, wherein the solder application pad (220) of the pen (2), in a wetting step for wetting with the solder paste, is firstly at least partially placed in a reservoir containing a solder paste, and the wetted solder application pad (220) is then placed, in a transfer step, on the desired contact point on the printed circuit board so that the solder paste can be applied or transferred to the at least one contact point on the printed circuit board;
- equipping the printed circuit board with a replacement component anticipated for the defective component;
- soldering on the replacement component.

2. The method as claimed in claim 1, wherein the main body (221) has a square cross-section orthogonally to the axis of rotation (RA) of the rod-shaped element (210).

3. The method as claimed in claim 1, wherein the main body (221) has a circular cross-section orthogonally to the axis of rotation (RA) of the rod-shaped element (210).

4. The method as claimed in any one of the preceding claims, wherein the main body (221) is coated, and wherein the end face (A_{S}) of the main body (221) and the pin (222) are uncoated.

5. The method as claimed in any one of the preceding claims, wherein the rod-shaped element (210) and the main body (221) are a common, one-piece component.

6. The method as claimed in any one of claims 1 to 4, wherein the rod-shaped element (210) and the main body (221) are connected to one another form-fittingly and/or with frictional engagement.

7. The method as claimed in any one of the preceding claims, wherein the pen (2), except for the pin (222), consists of two half-shells (HS1, HS2), which are connectable along the axis of rotation (RA), wherein the pin (222) has a fastening element (223) at a second end region, and wherein the main body (221) has a fitting (224) for securing the pin (222) once the half-shells (HS 1, HS2) have been joined together, and wherein the geometry of the fitting (224) corresponds substantially to the geometry of the securing element (223).

8. The method as claimed in claim 7, wherein the securing element (223), in the axial direction of the pin (222), is wedge-shaped, cylindrical, or is formed as a combination of wedge-shaped and cylindrical.

## Revendications

1. Procédé destiné à la réparation d'une carte de circuit imprimé comportant au moins un composant défectueux, le composant défectueux étant relié mécaniquement et/ou électriquement à la carte de circuit imprimé par l'intermédiaire d'au moins un point de contact situé côté carte de circuit imprimé, **caractérisé par** :
l'utilisation d'une tige (2), la tige (2) comprenant :
- un élément en forme de tige (210) avec un axe de rotation (RA) dans la direction longitudinale ;
- un poinçon d'application de soudure (220), lequel est constitué d'un corps de base (221) avec une face frontale (Aₛ) et d'une broche (222) faisant saillie de la face frontale (Aₛ), le poinçon d'application de soudure (220) présentant un axe longitudinal (LA1) et étant fixé à une zone d'extrémité de l'élément en forme de tige (210) de telle sorte que l'axe longitudinal (LA1) du corps de base (221) se trouve sur un prolongement de l'axe de rotation (RA) de l'élément en forme de tige (210),
la broche (222) présentant un axe longitudinal (LA2) et étant disposée de telle sorte que l'axe longitudinal (LA2) de la broche (222) se trouve sur un prolongement de l'axe de rotation (RA) de l'élément en forme de tige (210),
la face frontale (Aₛ) étant conçue avec une symétrie de rotation par rapport à l'axe longitudinal (LA2) de la broche (222), et
la broche (222) présentant une surface en saillie (Aᵥ) au niveau d'une première zone d'extrémité
et la surface en saillie étant plus petite que la surface d'extrémité (Aₛ) ; la broche (222) étant de conception cylindrique et
la surface d'extrémité (Aₛ) étant conçue de telle sorte que l'angle (α) entre l'axe longitudinal (LA2) de la broche (222) et la surface d'extrémité (Aₛ) est inférieur à 180°, de préférence compris entre 60° et 120°, particulièrement de préférence pour l'essentiel égal à 90°,
le procédé comprenant au moins les étapes suivantes :
- Retrait du composant défectueux de la carte de circuit imprimé ;
- Nettoyage de l'au moins un point de contact côté carte de circuit imprimé ;
- Application d'une pâte à souder sur l'au moins un point de contact nettoyé côté carte de circuit imprimé au moyen de la tige (2), le poinçon d'application de soudure (220) de la tige (2) étant d'abord déposé au moins partiellement dans un réservoir avec de la pâte à souder dans une étape de mouillage pour le mouillage avec la pâte à souder, le poinçon d'application de soudure (220) mouillé étant ensuite déposé sur le point de contact souhaité côté carte de circuit imprimé dans une étape de transfert, de manière à permettre l'application ou le transfert de la pâte à souder sur l'au moins un point de contact côté carte de circuit imprimé ;
- Équipement de la carte de circuit imprimé avec un composant de remplacement prévu pour le composant défectueux ;
- Soudage du composant de remplacement.

2. Procédé selon la revendication 1, pour lequel le corps de base (221) présente une section transversale carrée orthogonale à l'axe de rotation (RA) de l'élément en forme de tige (210).

3. Procédé selon la revendication 1, pour lequel le corps de base (221) présente une section transversale circulaire orthogonale à l'axe de rotation (RA) de l'élément en forme de tige (210).

4. Procédé selon l'une des revendications précédentes,
pour lequel le corps de base (221) est revêtu et
pour lequel la surface frontale (Aₛ) du corps de base (221) et la broche (222) ne sont pas revêtues.

5. Procédé selon l'une des revendications précédentes, pour lequel l'élément en forme de tige (210) et le corps de base (221) sont un composant commun d'une seule pièce.

6. Procédé selon l'une des revendications 1 à 4, pour lequel l'élément en forme de tige (210) et le corps de base (221) sont reliés entre eux par une liaison de forme et/ou de matière.

7. Procédé selon l'une des revendications précédentes, pour lequel la tige (2) est constituée, à l'exception de la broche (222), de deux demi-coques (HS1, HS2), lesquelles peuvent être reliées le long de l'axe de rotation (RA), la broche (222) présentant un élément de fixation (223) sur une deuxième zone d'extrémité et le corps de base (221) présentant une douille (224) destinée à fixer la broche (222) après assemblage des demi-coques (HS1, HS2), et la géométrie de la douille (224) correspondant pour l'essentiel à la géométrie de l'élément de fixation (223).

8. Procédé selon la revendication 7, pour lequel l'élément de fixation (223) est conçu en forme de coin, en forme de cylindre ou en forme combinée de coin et de cylindre dans la direction axiale de la broche (222).
